# EUROPEAN PATENT SPECIFICATION

(11) **EP 0 551 858 B1**
(45) Date of publication and mention of the grant of the patent: **03.05.2000**
(21) Application number: 93100299.2
(22) Date of filing: 11.01.1993
(51) Int. Cl.: H04N 7/00, H03K 5/08, G01R 19/165, H04L 25/49

(54) **Duobinary to binary decoder**
Duobinär/binär Dekoder
Décodeur duobinaire/binaire

(30) Priority: 15.01.1992 KR 50392
(43) Date of publication of application: 21.07.1993
(73) Proprietor: SAMSUNG ELECTRONICS CO., LTD., Suwon-City, Kyounggi-Do 441-370 (KR)
(72) Inventor: Cho, Hyun Duk, Suwon-City, Kyungki-Do (KR)
(74) Representative: Grünecker, Kinkeldey, Stockmair & Schwanhäusser Anwaltssozietät

(56) References cited:
- EP-A- 0 339 727
- GB-A- 1 155 576
- US-A- 4 007 382

## Description

The invention relates to a duobinary to binary decoder according to the preamble of claim 1.

GB-A-1155576 discloses a circuit arrangement for signifying the upper and lower limits of a voltage. More specifically it relates to an electronic circuit which includes triggering circuitry adapted to provide an output signal signifying that an input signal, applied to the circuit, has passed through pre-arranged upper and lower limits. A phase inverter formed by a complementary pair of transistors is used so as to avoid the use of differently dimensioned trigger circuits US-A-4007382 discloses a bi-polar signal processing circuit wherein a bi-polar signal is recovered and separated into its positive portion and its negative portion. The incoming bi-polar signal and its inverted form are separately compared to a switched threshold. Switching of the threshold is effected by a feedback of the output signals of the circuit. The circuit generates a switched reference signal which is applied to two comparator circuits, one for the bi-polar signal, the other for the inverted bi-polar signal, and a hysterisis generator switches the threshold to its high level when a comparator circuit produces an output signal.

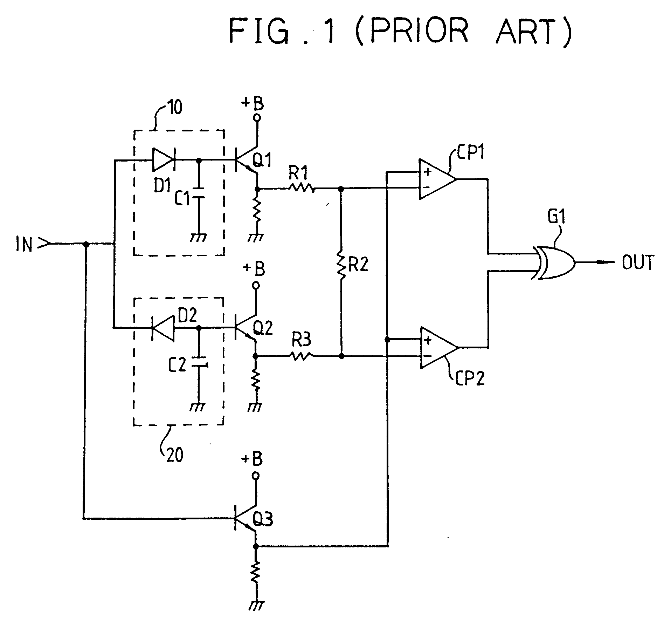

Generally, a TV or VCR adopting a MAC signal processing method includes a MAC signal receiver for receiving the MAC signal. The MAC signal is received as a signal of a state of duobinary data in the MAC signal receiver. For the purpose of digital-processing information included in the received signal, the duobinary data should be converted into binary data. An example of a conventional duobinary to binary decoder for converting duobinary data of the MAC signal into binary data is shown in FIG.1.

In FIG.1, the conventional duobinary to binary decoder comprises an input terminal IN to which a duobinary signal of the received MAC signal is input, an upper peak detector 10 for detecting a peak value of a positive region in the input signal, a lower peak detection circuit 20 (hereinafter referred to as lower peak detector for detecting a peak value of a negative region in the input signal, a first comparator CP1 which receives a duobinary signal as a comparison signal and an output of upper peak detector 10 as a reference voltage signal, so as to produce binary data corresponding to the positive region of the duobinary signal, a second comparator CP2 which receives the duobinary signal as a comparison signal and an output of lower peak detector 20 as a reference voltage signal, so as to produce binary data corresponding to the negative region of the duobinary signal, an exclusive-OR gate G1 which exclusive-OR-operates output data of first and second comparators CP1 and CP2 to produce binary data.

The duobinary signal input through input terminal IN is added with a certain magnitude of DC voltage (+B) in a third transistor Q3 and then the added signal is input to non-inverting terminals (+) of first and second comparators CP1 and CP2, respectively. Upper peak detector 10 and lower peak detector 20 which are connected to input terminal IN in parallel to each other detect the upper peak value and the lower peak value of the input duobinary signal, respectively. Here, upper peak detector 10 comprises a forward first diode D1 and a first capacitor C1, and lower peak detector 20 comprises a backward second diode D2 and a second capacitor C2. The upper peak value detected in upper peak detector 10 is added with a certain DC voltage (+B) in a first transistor Q1, and the lower peak value detected in lower peak detector 20 is added with a certain DC voltage (+B) in a second transistor Q2. The emitter signals of first and second transistors Q1 and Q2 are supplied to inverting terminals (-) of first and second comparators CP1 and CP2, respectively. At this time, The respective emitter signals to be supplied to inverting terminals of first and second comparators CP1 and CP2, are voltage-divided via three resistors R1, R2 and R3. That is, the magnitude level of the signal applied in each of the inverting terminals of first and second comparators are adjusted by three resistors R1, R2 and R3. In first comparator CP1 and second comparator CP2, the signal input in inverting terminal (-) is the reference signal with which the duobinary signal input in non-inverting terminal (+) is compared. Accordingly, when the level of the duobinary signal is higher that that of the reference signal, a logic "1" is output, while when the level of the duobinary signal is lower that that of the reference signal, a logic "0" is output. Therefore, the binary data corresponding to the positive and negative regions of the duobinary signal is output from first and second comparators. The respective outputs of first and second comparators CP1 and CP2 are exclusive-OR-operated in exclusive-OR gate G1, to obtain the binary signal corresponding to the duobinary signal from output terminal OUT. Such a conventional duobinary to binary decoder is disclosed in detail in European application EP 0,339,727 A2.

However, when the above-mentioned conventional duobinary to binary decoder detects the lower peak value which exists in the negative region of the duobinary signal, it was difficult to obtain stable detection data and to maintain the detected peak value. Also, during an actual operation of the decoder circuit, a reference DC level of the duobinary signal was lowered.

It is the object of the invention to provide an improved duobinary to binary decoder allowing a better determination of a peak.

This object is solved by the subject matter of claim 1. Further advantages embodiments of the invention are subject matter of the dependend claims.

A preferred embodiment of the invention will be described below in more detail with reference to the accompanying drawings.
FIG.1 is an examplary circuit diagram of a conventional duobinary to binary decoder.
FIG.2 is a circuit diagram of a duobinary to binary decoder according to the present invention.
FIGs.3A to 3D are waveform diagrams showing inputs and outputs of the essential parts of the circuit shown in FlG.2.

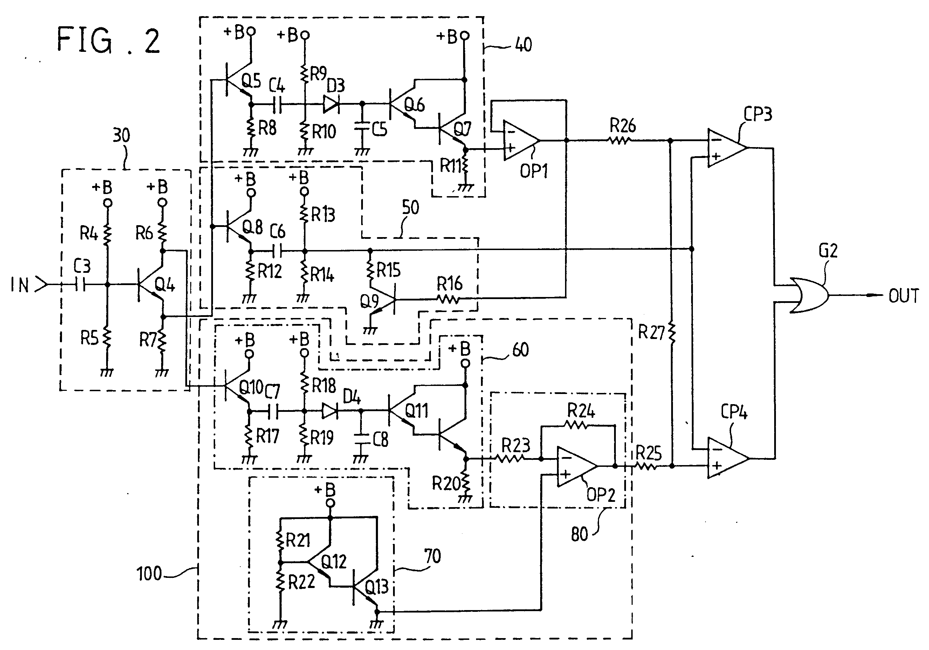

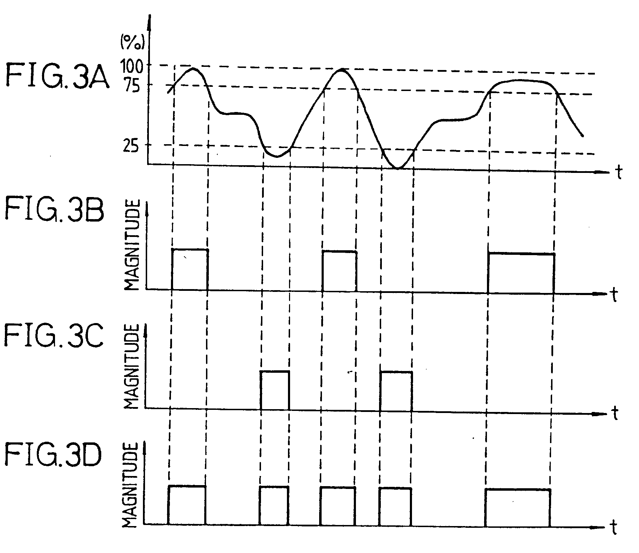

In FIG.2 which shows one embodiment of a duobinary to binary decoder according to the present invention, a MAC signal of a duobianry type as shown in FIG.3A is input through input terminal IN. the input duobinary signal is first supplied to a pushpull circuit 30. Then, the duobianry signal is AC-coupled by a capacitor C3 in pushpull circuit 30. And then, the AC-coupled duobinary signal is added with a certain DC voltage by means of an external DC bias voltage source (+B) and two resistors R4 and R5. Then, the duobinary signal is applied to a base electrode of a transistor Q4. At this time, an inverting signal of the duobinary signal input to the base electrode is output from the collector electrode of transistor Q4, while the non-inverting signal thereof is output from the emitter electrode. Such a non-inverting signal output from pushpull circuit 30 is supplied to an upper peak detector 40 and a DC level regulator 50, respectively. The non-inverting signal applied to upper peak detector 40 is input to the base electrode of a transistor Q5. Then, the signal output from the emitter electrode of trnasistor Q5 is AC-coupled by a capacitor C4, and is added with a certain DC voltage by means of two resistors R9 and R10 and a DC bias voltage source (+B). Then, an upper peak value of the non-inverting signal is detected by a diode D3 and a capacitor C5. The detection signal is current-amplified by an amplifying unit composed of two transistors Q6 and Q7, to then input to the non-inverting terminal (+) of a first operational amplifier OP1. First operational amplifier OP1 plays a role of buffering the output of upper peak detector 40.

On the other hand, DC level regulator 50 AC-couples the non-inverting signal supplied from pushpull circuit 30 using a transistor Q8 and a capacitor C6, and then adds the AC-coupled signal with a bias voltage by means of three resistors R13, R14 and R15 and a transistor Q9. At this time, a collector current of transistor Q9 is varied by a voltage applied to the base electrode, in which the base voltage is controlled by the voltage signal output from first operational amplifier OP1. That is, the output voltage of first operational amplifier OP1 controls the magnitude of the DC bias voltage which is added to the AC-coupled duobinary signal. The reason why the output voltage of upper peak detector 40 is fedback to DC level regulator 50 is that when a bias voltage having a certain level is added to the AC-coupled duobinary signal, since the DC level of the original duobinary signal is varied to alter a peak value, such a variation of the DC level is compensated by being sensitively operated in correspondence to the variation, to accordingly maintain the DC level to be constant.

On the other hand, the inverting signal output from the collector electrode of transistor Q4 in pushpull circuit 30 is supplied to lower peak detector 100. Lower peak detector 100 comprises a second peak detector 60 (hereinafter referred to as (second) upper peak detector 60) for detecting an upper peak value of the input signal, inverter 80 (hereinafter referred to as re-inverter 80) for again inverting the output signal of upper peak detector 60, and a reference voltage supply unit 70 for supplying a predetermined reference voltage signal to re-inverter 80. The inverting signal output from pushpull circuit 30 is input to upper peak detector 60 included in lower peak detector 100. Upper peak detector 60 detects the upper peak value of the input inverting signal and re-inverts the detected upper peak value, to thereby detect the lower peak value of the original duobinary signal. That is, lower peak detector 100 receives the duobinary signal in which the negative region is inverted into the positive region, detects the upper peak value of the inverting signal in upper peak detector 60, and re-inverts the detected upper peak value in re-inverter 80, thereby detecting the lower peak value of the duobinary signal. At this time, reference voltage supply unit 70 including a DC bias voltage source (+B) and two transistors Q12 and Q13 generates a reference voltage signal which becomes a reference for inverting a signal which is input to inverting terminal (-) of a second operational amplifier OP2 in re-inverter 80, to then supply the reference voltage signal to the non-inverting signal (+) of second operational amplifier OP2 of re-inverter 80.

As described above, the upper peak value and the lower peak value respectively output from upper peak detector 40 and lower peak detector 100 are supplied to a third comparator CP3 and a fourth comparator CP4, respectively. The upper peak value of upper peak detector 40 is applied to the inverting terminal (-) of third comparator CP3, and the lower peak value of lower peak detector 100 is applied to the non-inverting terminal (+) of fourth comparator CP4. Also, the duobinary signal output from DC level regulator 50 is supplied to the non-inverting terminal (+) of third comparator CP3 and the inverting terminal (-) of fourth comparator CP4, respectively. Then, third comparator CP3 and fourth comparator CP4 performs data-slicing of the input duobinary signal, so that third comparator CP3 outputs the binary signal as shown in FIG.3B while fourth comparator CP4 outputs the binary signal as shown in FIG.3C. At this time, the data-slicing level is determined by means of three resistors R25, R26 and R27 connected in the input terminal of third and fourth comparators CP3 and CP4, respectively. If R25=R26=RΩ, and R27=2RΩ, as shown in FIG.3A, the duobinary signal is data-sliced at the level of 75% and 25% of the entire level, respectively. Then, third comparator CP3 produces a signal having a predetermined level as shown in FIG.3B with respect to the interval corresponding to not less than 75% of the level of the input duobinary signal. Fourth comparator CP4 produces a signal having a predetermined level as shown in FIG.3C with respect to the interval corresponding to not less than 25% of the level of the input duobinary signal. Such binary signals output respectively from third comparator CP3 and fourth comparator CP4, are logically operated in OR gate G2, so as to obtain a binary signal as shown in FIG.3D.

The duobinary to binary decoder according to the present invention enables other combinations of the shapes different from the embodiment shown in FIG.2. That is, in a relationship of connecting upper peak detector 40, DC level regulator 50 and lower peak detector 100 with transistor Q4 of pushpull circuit 30, it is possible to constitute another circuit in which the collector output of transistor Q4 in pushpull circuit 30 is applied to the base electrode of transistor Q10 in lower peak detector 100, and the emitter output thereof is applied to the base electrodes of transistor Q5 in upper peak detector 40 and of transistor Q8 in DC level regulator 50, respectively. Then, the inverting signal output from pushpull circuit 30 is input upper peak detector 40 and DC level regulator 50, while the non-inverting signal is input to lower peak detector 100. By doing so, through the same operation process as that of the above-described embodiment, the upper peak value and the lower peak value are detected, to thereby obtain the corresponding binary signal.

As described above, the duobinary to binary decoder according to the present invention can obtain more stable data in detecting the lower peak value of the negative region in the duobinary signal, and maintain the DC level of the duobinary signal constantly by feeding back the detected peak value data and regulating the DC level of the duobinary signal.

## Claims

1. A duobinary to binary decoder for use in an apparatus for converting a duobinary signal of a multiplexed analog component signal into a binary signal, said duobinary to binary decoder comprising:
an upper peak detector (40) for receiving a first duobinary signal and for detecting an upper peak value thereof;
a lower peak detection circuit (100) for receiving a second duobinary signal and for detecting a lower peak value thereof;
a DC level regulator (50) for also receiving the first duobinary signal and for regulating and outputting the DC level of said first duobinary signal; and
a comparison operation portion (CP3; CP4; G2) for comparing the outputs of said upper peak detector (40) and said lower peak detection circuit (100) with a particular signal level;
**characterized in that**
the upper peak detector (40) feeds back the detected upper peak value to the DC level regulator (50);
the DC level regulator (50) regulates the DC level of the first duobinary signal so as to maintain it constant, according to the fed back value;
the particular signal level is identical to the DC level of the first duobinary signal outputted by said DC level regulator (50);
a) a pushpull circuit (30) adds a predetermined DC voltage to said duobinary signal input to said decoder and outputs said first and second duobinary signals based on said DC voltage; wherein the first and the second duobinary signal correspond to the non-inverted and inverted input duobinary signal, respectively; and wherein said pushpull circuit (30) comprises:
a1) a capacitor (C3) for AC-coupling said input duobinary signal;
a2) means (+B, R4, R5) for adding said predetermined DC voltage to said AC-coupled signal; and
a3) a transistor (Q4) for inverting and non-inverting said AC-coupled duobinary signals based on said predetermined DC voltage and wherein
b) said lower peak detection circuit (100) comprises:
b1) a second peak detector (60) for detecting a peak value of the second duobinary signal supplied from said pushpull circuit (30); and
b2) a reference voltage supply source (70) for supplying a predetermined reference voltage to an inverter (80); wherein
b3) the inverter (80) inverts the output of said second peak detector (60) under consideration of said predetermined reference voltage.

2. The duobinary to binary decoder according to claim 1, characterized in that said upper peak detector (40) comprises:
a capacitor (C4) for AC-coupling the input first duobinary signal;
means (+B, R9, R10) for adding said predetermined DC voltage to said AC-coupled signal; and
a peak value detector (D3; C5) for detecting an upper peak value of the first duobinary signal based on said DC voltage.

3. The duobinary to binary decoder according to claim 1 or 2, characterized in that said second peak detector (60) comprises:
a capacitor (C7) for AC coupling the input second duobinary signal;
means (+B, R18, R19) for adding said predetermined DC voltage to said AC-coupled signal; and
a peak value detector (D4, C8) for detecting a peak value of the second duobinary signal based on said DC voltage.

4. The duobinary to binary decoder according to claim 2 or 3, characterized in that any of said peak value detectors (D3, C5, D4, C8) comprises:
a diode (D3; D4) which is connected in a forward direction with respect to said input first or second duobinary signal; and
a capacitor (C5; C8) which is connected to the output terminal of said diode
(D3; D4).

5. The duobinary to binary decoder according to one of claims 1 to 4, characterized in that the inverter (80) is a comparator (OP2) in which the output of said second peak detector (60) is received at the inverting terminal of said comparator (OP2), and the output of said reference voltage supply source (70) is received at the non-inverting terminal.

6. The duobinary to binary decoder according to any one of claims 1 to 5, characterized in that said DC level regulator (50) comprises:
a capacitor (C6) for AC-coupling the first duobinary signal supplied from said pushpull circuit (30);
means (+B, R13, R14) for adding said predetermined DC voltage to said AC-coupled signal; and
a transistor (Q9) which is connected with said DC adding means (+B, R13, R14) and for receiving the output of said upper peak detector (40) and regulating the DC value of said DC adding means based on the received signal.

7. The duobinary to binary decoder according to any one of claims 1 to 6, characterized in that said comparison operation portion (CP3, CP4, G2) comprises:
means (R25, R26, R27) for receiving the signals respectively output from said upper and lower peak detection circuit (40; 100) and setting predetermined upper and lower levels;
means (CP3, CP4) for data-slicing the duobinary signal output from said DC level regulator (50) according to the upper and lower levels set in said level set means; and
a logic unit (G2) for logically operating data obtained by data slicing in the upper and lower levels, respectively in said data-slicing means to then output a binary signal.

8. The duobinary to binary decoder according to claim 7, characterized in that said data-slicing means (CP3, CP4) comprises:
a first comparator (CP3) in which the upper level set in said level set means (R25,...) is applied to one input terminal, and the output of said DC level regulator (50) is applied to the other input terminal, thereby outputting a predetermined level signal only when the output of said DC level regulator is higher than said upper level; and
a second comparator (CP4) in which the lower level set in said level set means (R25,...) is applied to one input terminal, and the output of said DC level regulator is applied to the other input terminal, thereby outputting a predetermined level signal only when the output of said DC level regulator is lower than said lower level.

9. The duobinary to binary decoder according to claim 7 or 8, characterized in that said level set means (R25, R26, R27) comprises:
a first resistor (R26) which is connected between the output terminal of said upper peak detector (40) and the upper level input terminal of said first comparator (CP3);
a second resistor (R25) which is connected between the output terminal of said lower peak detection circuit (100) and the lower level input terminal of said second comparator (CP4), and
a third resistor (R27) which is connected between said first resistor (R26) and said second resistor.

## Patentansprüche

1. Duobinär/Binär-Decodierer zur Verwendung in einer Vorrichtung zum Wandeln eines Duobinär-Signals eines im Multiplex-Verfahren verarbeiteten Signals mit analogen Komponenten in ein Binär-Signal, wobei der Duobinär/Binär-Decodierer aufweist:
einen oberen Peak-Detektor (40) zum Aufnehmen eines ersten Duobinär-Signals und zum Erfassen eines oberen Peak-Werts davon;
einen unteren Peak-Erfassungsschaltkreis (100) zum Aufnehmen eines zweiten Duobinär-Signals und zum Erfassen eines unteren Peak-Werts davon;
einen DC-Pegel-Regulator (50) auch zum Aufnehmen des ersten Duobinär-Signals und zum Regulieren und Ausgeben des DC-Pegels des ersten Duobinär-Signals; und
einen Vergleichsoperationsbereich (CP3; CP4; G2) zum Vergleichen der Ausgänge des oberen Peak-Detektors (40) und des unteren Peak-Erfassungsschaltkreises (100) mit einem bestimmten Signalpegel;
dadurch gekennzeichnet, daß
der obere Peak-Detektor (40) den erfaßten, oberen Peak-Wert zu dem DC-Pegel-Regulator (50) zurückführt;
der DC-Pegel-Regulator (50) den DC-Pegel des ersten Duobinär-Signals so reguliert, um ihn konstant, entsprechend dem Rückführwert, beizubehalten;
wobei der bestimmte Signalpegel identisch zu dem DC-Pegel des ersten Duobinär-Signals ist, das durch den DC-Pegel-Regulator (50) ausgegeben ist; wobei
a) ein Gegentaktschaltkreis (30) eine vorbestimmte DC-Spannung zu dem Duobinär- Signal, das zu dem Decodierer eingegeben ist, hinzufügt und das erste und das zweite Duobinär-Signal basierend auf der DC-Spannung ausgibt; wobei das erste und das zweite Duobinär-Signal dem nicht invertierten und dem invertierten Eingangs-Duobinär-Signal jeweils entspricht; und wobei der Gegentaktschaltkreis (30) aufweist:
a1) einen Kondensator (C3) für eine AC-Kopplung des eingegebenen Duobinär-Signals;
a2) eine Einrichtung (+B, R4, R5) zum Hinzufügen der vorbestimmten DC-Spannung zu dem AC-gekoppelten Signal; und
a3) einen Transistor (Q4) zum Invertieren und Nicht-Invertieren der AC-gekoppelten Duobinär-Signale basierend auf der vorbestimmten DC-Spannung, und wobei
b) der untere Peak-Erfassungsschaltkreis (100) aufweist:
b1) einen zweiten Peak-Detektor (60) zum Erfassen eines Peak-Werts des zweiten Duobinär-Signals, das von dem Gegentaktschaltkreis (30) zugeführt ist; und
b2) eine Referenzspannungsversorgungsquelle (70) zum Zuführen einer vorbestimmten Referenzspannung zu einem Inverter (80); wobei
b3) der Inverter (80) den Ausgang des zweiten Peak-Detektors (60) unter Berücksichtigung der vorbestimmten Referenzspannung invertiert.

2. Duobinär/Binär-Decodierer nach Anspruch 1, dadurch gekennzeichnet, daß der obere Peak-Detektor (40) aufweist:
einen Kondensator (C4) zum AC-Koppeln des eingegebenen ersten Duobinär-Signals; Mittel (+B, R9, R10) zum Hinzufügen der vorbestimmten DC-Spannung zu dem AC-gekoppelten Signal; und
einen Peak-Wert-Detektor (D3; C5) zum Erfassen eines oberen Peak-Werts des ersten Duobinär-Signals basierend auf der DC-Spannung.

3. Duobinär/Binär-Decodierer nach Anspruch 1 oder 2, dadurch gekennzeichnet, daß der zweite Peak-Detektor (60) aufweist:
einen Kondensator (C7) zum AC-Koppeln des eingegebenen zweiten Duobinär-Signals; Mittel (+B, R18, R19) zum Hinzufügen der vorbestimmten DC-Spannung zu dem AC-gekoppelten Signal; und
einen Peak-Wert-Detektor (D4, C8) zum Erfassen eines Peak-Werts des zweiten Duobinär-Signals basierend auf der DC-Spannung.

4. Duobinär/Binär-Decodierer nach Anspruch 2 oder 3, dadurch gekennzeichnet, daß irgendeiner der Peak-Wert-Detektoren (D3, C5, D4, C8) aufweist:
eine Diode (D3; D4), die in einer Vorwärtsrichtung in Bezug auf das eingegebene erste oder zweite Duobinär-Signal verbunden ist; und
einen Kondensator (C5; C8), der mit dem Ausgangsanschluß der Diode (D3; D4) verbunden ist.

5. Duobinär/Binär-Decodierer nach einem der Ansprüche 1 bis 4, dadurch gekennzeichnet, daß der Inverter (80) ein Komparator (OP2) ist, in dem der Ausgang des zweiten Peak-Detektors (60) an dem invertierenden Anschluß des Komparators (OP2) aufgenommen wird und der Ausgang der Referenzspannungsversorgungsquelle (70) an dem nicht invertierenden Anschluß aufgenommen wird.

6. Duobinär/Binär-Decodierer nach einem der Ansprüche 1 bis 5, dadurch gekennzeichnet, daß der DC-Pegel-Regulator (50) aufweist:
einen Kondensator (C6) zum AC-Koppeln des ersten Duobinär-Signals, das von dem Gegentaktschaltkreis (30) zugeführt ist;
Mittel (+B, R13, R14) zum Hinzufügen der vorbestimmten DC-Spannung zu dem AC-gekoppelten Signal; und
einen Transistor (Q9), der mit dem die DC-Spannung hinzufügenden Mittel (+B, R13, R14) und zum Aufnehmen des Ausgangs des oberen Peak-Detektors (40) verbunden ist und den DC-Wert des die DC-Spannung hinzufügenden Mittels basierend auf dem empfangenen Signal reguliert.

7. Duobinär/Binär-Decodierer nach einem der Ansprüche 1 bis 6, dadurch gekennzeichnet, daß der Vergleichsoperationsbereich (CP3, CP4, G2) aufweist:
Mittel (R25, R26, R27) zum Aufnehmen der Signale jeweils, die von dem oberen und dem unteren Peak-Erfassungsschaltkreis (40; 100) ausgegeben sind, und zum Einstellen vorbestimmter oberer und unterer Pegel;
Mittel (CP3, CP4) für eine Datenunterteilung des Duobinär-Signalausgangs von dem DC-Pegel-Regulator (50) gemäß dem oberen und dem unteren Pegel, die in der Pegeleinstelleinrichtung eingestellt sind; und
eine logische Einheit (G2) zum logischen Verabeiten von Daten, die durch die Datenunterteilung in den oberen und den unteren Pegel jeweils in den Datenunterteilungsmitteln erhalten sind, um dann ein binäres Signal auszugeben.

8. Duobinär/Binär-Decodierer nach Anspruch 7, dadurch gekennzeichnet, daß das Datenunterteilungsmittel (CP3, CP4) aufweist:
einen ersten Komparator (CP3), in dem der obere Pegel, der in den Pegeleinstellmitteln (R25, ...) eingestellt ist, an einen Eingangsanschluß angelegt wird, und der Ausgang des DC-Pegel-Regulators (50) an den anderen Eingangsanschluß angelegt wird, um dadurch ein Signal mit einem vorbestimmten Pegel nur dann auszugeben, wenn der Ausgang des DC-Pegel-Regulators höher als der obere Pegel ist; und
einen zweiten Komparator (CP4), in dem der untere Pegel, der in den Pegeleinstellmitteln (R25, ...) eingestellt ist, an einen Eingangsanschluß angelegt wird, und der Ausgang des DC-Pegel-Regulators an den anderen Eingangsanschluß, angelegt wird, um dadurch ein Signal mit einem vorbestimmten Pegel nur dann auszugeben, wenn der Ausgang des DC-Pegel-Regulators niedriger als der untere Pegel ist.

9. Duobinär/Binär-Decodierer nach Anspruch 7 der 8, dadurch gekennzeichnet, daß die Pegeleinstellmittel (R25, R26, R27) aufweisen:
einen ersten Widerstand (R26), der zwischen dem Ausgangsanschluß des oberen Peak-Detektors (40) und dem Eingangsanschluß für den oberen Pegel des ersten Komparators (CP3) verbunden ist;
einen zweiten Widerstand (R25), der zwischen dem Ausgangsanschluß des unteren Peak-Erfassungsschaltkreises (100) und dem Eingangsanschluß für den unteren Pegel des zweiten Komparators (CP4) verbunden ist; und
einen dritten Widerstand (R27), der zwischen dem ersten Widerstand (R26) und dem zweiten Widerstand verbunden ist.

## Revendications

1. Décodeur duobinaire/binaire à utiliser dans un dispositif de transformation d'un signal duobinaire d'un signal à composante analogique multiplexée en un signal binaire, ledit décodeur duobinaire/binaire comprenant :
un détecteur de pic supérieur (40) pour recevoir un premier signal duobinaire et pour détecter une valeur de pic supérieur de ce dernier ;
un circuit de détection de pic inférieur (100) pour recevoir un second signal duobinaire et pour détecter une valeur de pic inférieur de ce dernier ;
un régulateur de niveau de courant continu (50) pour recevoir également le premier signal duobinaire et pour réguler et sortir le niveau de courant continu dudit premier signal duobinaire ; et
une partie de mise en oeuvre de comparaison (CP3 ; CP4 ; G2) pour comparer les sorties dudit détecteur de pic supérieur (40) et dudit circuit de détection de pic inférieur (100) à un niveau de signal particulier ;
**caractérisé en ce que**
le détecteur de pic supérieur (40) renvoie la valeur de pic supérieur détectée au régulateur de niveau de courant continu (50) ;
le régulateur de niveau de courant continu (50) régule le niveau de courant continu du premier signal duobinaire de façon à le maintenir constant, selon la valeur renvoyée ;
le niveau de signal particulier est identique au niveau de courant continu du premier signal duobinaire sorti par ledit régulateur de niveau de courant continu (50) ;
a) un circuit symétrique (30) ajoute une tension continue prédéterminée audit signal duobinaire entré dans ledit décodeur et sort lesdits premier et second signaux duobinaires sur la base de ladite tension continue ; dans lequel les premier et second signaux duobinaires correspondent respectivement au signal duobinaire d'entrée non inversé et au signal duobinaire d'entrée inversé ; et dans lequel ledit circuit symétrique (30) comprend :
a1) un condensateur (C3) pour une liaison en courant alternatif dudit signal duobinaire d'entrée ;
a2) des moyens (+ B, R4, R5) pour ajouter ladite tension continue prédéterminée audit signal à liaison en courant alternatif ; et
a3) un transistor (Q4) pour l'inversion et la non-inversion desdits signaux duobinaires à liaison en courant alternatif sur la base de ladite tension continue prédéterminée, et dans lequel
b) ledit circuit de détection de pic inférieur (100) comprend :
b1) un second détecteur de pic (60) pour détecter une valeur de pic du second signal duobinaire amené en provenance dudit circuit symétrique (30) ; et
b2) une source d'alimentation en tension de référence (70) pour amener une tension de référence prédéterminée à un inverseur (80) ; dans lequel
b3) l'inverseur (80) inverse la sortie dudit second détecteur de pic (60) en considérant ladite tension de référence prédéterminée.

2. Décodeur duobinaire/binaire selon la revendication 1, caractérisé en ce que ledit détecteur de pic supérieur (40) comprend :
un condensateur (C4) pour une liaison en courant alternatif dudit premier signal duobinaire d'entrée ;
des moyens (+ B, R9, R10) pour ajouter ladite tension continue prédéterminée audit signal à liaison en courant alternatif ; et
un détecteur de valeur de pic (D3 ; C5) pour détecter une valeur de pic supérieur du premier signal duobinaire sur la base de ladite tension continue.

3. Décodeur duobinaire/binaire selon la revendication 1 ou 2, caractérisé en ce que ledit second détecteur de pic (60) comprend :
un condensateur (C7) pour une liaison en courant alternatif du second signal duobinaire d'entrée ;
des moyens (+ B, R18, R19) pour ajouter ladite tension continue prédéterminée audit signal à liaison en courant alternatif ; et
un détecteur de valeur de pic (D4 ; C8) pour détecter une valeur de pic du second signal duobinaire sur la base de ladite tension continue.

4. Décodeur duobinaire/binaire selon la revendication 2 ou 3, caractérisé en ce que l'un quelconque desdits détecteurs de valeur de pic (D3, C5, D4, C8) comprend :
une diode (D3 ; D4) qui est reliée dans le sens direct par rapport audit premier ou second signal duobinaire d'entrée ; et
un condensateur (C5 ; C8) qui est relié à la borne de sortie de ladite diode (D3 ; D4).

5. Décodeur duobinaire/binaire selon l'une des revendications 1 à 4, caractérisé en ce que l'inverseur (80) est un comparateur (OP2) dans lequel la sortie dudit second détecteur de pic (60) est reçue au niveau de la borne inverseuse dudit comparateur (OP2), et la sortie de ladite source d'alimentation en tension de référence (70) est reçue au niveau de la borne non inverseuse.

6. Décodeur duobinaire/binaire selon l'une quelconque des revendications 1 à 5, caractérisé en ce que ledit régulateur de niveau de courant continu (50) comprend :
un condensateur (C6) pour une liaison en courant alternatif du premier signal duobinaire amené en provenance dudit circuit symétrique (30) ;
des moyens (+ B, R13, R14) pour ajouter ladite tension continue prédéterminée audit signal à liaison en courant alternatif ; et
un transistor (Q9) qui est relié auxdits moyens d'ajout de courant continu (+ B, R13, R14) et pour recevoir la sortie dudit détecteur de pic supérieur (40) et pour réguler la valeur de courant continu desdits moyens d'ajout de courant continu sur la base du signal reçu.

7. Décodeur duobinaire/binaire selon l'une quelconque des revendications 1 à 6, caractérisé en ce que ladite partie de mise en oeuvre de comparaison (CP3, CP4, G2) comprend :
des moyens (R25, R26, R27) pour recevoir les signaux respectivement sortis en provenance desdits circuits de détection de pic supérieur et inférieur (40 ; 100) et pour fixer les niveaux supérieur et inférieur prédéterminés ;
des moyens (CP3, CP4) pour le découpage en données du signal duobinaire sorti en provenance dudit régulateur de niveau de courant continu (50) selon les niveaux supérieur et inférieur fixés dans lesdits moyens de fixation de niveau ; et
une unité logique (G2) pour faire subir une opération logique aux données obtenues par découpage en données selon les niveaux supérieur et inférieur, respectivement dans lesdits moyens de découpage en données pour sortir ensuite un signal binaire.

8. Décodeur duobinaire/binaire selon la revendication 7, caractérisé en ce que lesdits moyens de découpage en données (CP3, CP4) comprennent :
un premier comparateur (CP3) dans lequel le niveau supérieur fixé dans lesdits moyens de fixation de niveau (R25, ...) est appliqué à une borne d'entrée particulière, et la sortie dudit régulateur de niveau de courant continu (50) est appliquée à l'autre borne d'entrée, sortant, de ce fait, un signal de niveau prédéterminé seulement si la sortie dudit régulateur de niveau de courant continu est supérieure audit niveau supérieur ; et
un second comparateur (CP4) dans lequel le niveau inférieur fixé dans lesdits moyens de fixation de niveau (R25, ...) est appliqué à une borne d'entrée particulière, et la sortie dudit régulateur de niveau de courant continu est appliquée à l'autre borne d'entrée, sortant, de ce fait, un signal de niveau prédéterminé seulement si la sortie dudit régulateur de niveau de courant continu est inférieure audit niveau inférieur.

9. Décodeur duobinaire/binaire selon la revendication 7 ou 8, caractérisé en ce que lesdits moyens de fixation de niveau (R25, R26, R27) comprennent :
une première résistance (R26) qui est reliée entre la borne de sortie dudit détecteur de pic supérieur (40) et la borne d'entrée de niveau supérieur dudit premier comparateur (CP3) ;
une deuxième résistance (R25) qui est reliée entre la borne de sortie dudit circuit de détection de pic inférieur (100) et la borne d'entrée de niveau inférieur dudit second comparateur (CP4) ; et
une troisième résistance (R27) qui est reliée entre ladite première résistance (R26) et ladite deuxième résistance.
